# EUROPEAN PATENT APPLICATION

(11) **EP 4 529 102 A1**
(43) Date of publication of application: **26.03.2025**
(21) Application number: 23807339.9
(22) Date of filing: 13.04.2023
(51) Int. Cl.: H04L 25/03, H01M 10/48, H02J 7/00, H04L 25/02

(54) **IDENTIFICATION INFORMATION RECEIVING DEVICE, ENERGY STORAGE PACK, AND IDENTIFICATION INFORMATION RECEIVING METHOD**

(30) Priority: 19.05.2022 JP 2022082178
(71) Applicant: Panasonic Intellectual Property Management Co., Ltd., Kadoma-shi, Osaka 571-0057 (JP)
(72) Inventor: HAMAMOTO Katsuaki, Kadoma-shi, Osaka 571-0057 (JP); KURANUKI Masaaki, Kadoma-shi, Osaka 571-0057 (JP)
(74) Representative: Novagraaf International SA
(86) International application number: PCT/JP2023/014988
(87) International publication number: WO 2023/223726

(57) **Abstract**

**In** an identification information receiving device connected to an identification information transmitting device by a power line, a measurement value obtainment unit obtains a measurement value of an electric current or a voltage in the power line. An identification information reading unit reads, as binary data, identification information defined by a plurality of bits and superimposed on the electric current or the voltage in the power line by the identification information transmitting device, by determining whether the measurement value corresponding to each bit of the identification information is greater or less than a determination threshold value (other than 0). A threshold value setting unit sets the determination threshold value on the basis of an initial threshold value (other than 0) and the measurement value corresponding to each bit of threshold value verification information defined by a plurality of bits and superimposed on the electric current or the voltage in the power line by the identification information transmitting device before the identification information.

## Description

### Technical Field

The present disclosure relates to an identification information receiving device, an energy storage pack, and an identification information receiving method in which identification information superimposed on an electric current or a voltage in a power line is received.

### Background Art

In recent years, electric assisted bicycles have become popular. Detachable, portable battery packs are used in the electric assisted bicycles. In order to eliminate terminals for communication lines from connectors of the battery packs, a system has been developed in which a battery pack and an electric assisted bicycle include wireless communication functions and control signals are transmitted wirelessly.

When there is more than one electric assisted bicycle in the coverage area of wireless communication with a battery pack, another vehicle adjacent to a subject vehicle may accidentally control the battery pack attached to the subject vehicle, meaning that the safety and security of the whole system cannot be secured. Particularly, in many cases of a rental service, a sharing service, or the like, more than one electric assisted bicycle is parked in a single bicycle parking area. In order for safe and secure operation of the whole system, each electric assisted bicycle needs to properly identify a battery pack attached thereto.

Patent Literature (PTL) 1 discloses a method in which when a vehicle equipped with an energy storage device and an external power supply device are connected by a charging cable, the connection between the vehicle and the power supply device is checked using wireless communication.

The connection between the vehicle and the power supply device is recognized on the basis of a power transmission pattern of power supply and shut-off from the power supply device via wired communication and pattern information transmitted via wireless communication. The vehicle can obtain the information of the power transmission pattern by detecting power supply and shut-off.

Generally, light vehicles such as electric assisted bicycles do not include a dedicated battery for operating a control circuit and receive control power supply from a battery pack attached thereto for motive purpose. In this situation, even when identification information in the form of a power supply and shut-off pattern is transmitted from the battery pack to the vehicle through a power line, it is difficult for the vehicle to detect the identification information.

### Citation List

### Patent Literature

PTL 1: Unexamined Japanese Patent Publication No. 2011-125186

### Summary of Invention

It is conceivable that identification information in the form of a binary current (other than zero) or a binary voltage (other than zero) is superimposed on a power line while power is supplied from a battery pack to a vehicle through the power line. The receiving end receives the identification information by comparing the measurement value of the current or the voltage and a determination threshold value and assigning 1 to a measurement value greater than or equal to the determination threshold value and 0 to a measurement value less than the determination threshold value.

However, there is a possibility that an offset may be added to the electric current measurement value or the voltage measurement value due to variations in the characteristics of components or due to changes in electric current consumption, for example, and there may be cases where the identification information cannot be properly received when the determination threshold value is fixed.

The present disclosure is conceived in view of this situation and has an object to provide a technique to reduce false determination that may occur at the time of reading the identification information superimposed on an electric current or a voltage in the power line.

In order to solve the above problem, an identification information receiving device according to the present disclosure is connected to an identification information transmitting device by a power line and includes: a measurement value obtainment unit that obtains a measurement value of an electric current or a voltage in the power line; an identification information reading unit that reads identification information as binary data by determining whether the measurement value corresponding to each bit of the identification information is greater or less than a determination threshold value (other than 0), the identification information being defined by a plurality of bits and superimposed on the electric current or the voltage in the power line by the identification information transmitting device; and a threshold value setting unit that sets the determination threshold value on the basis of an initial threshold value (other than 0) and the measurement value corresponding to each bit of threshold value verification information defined by a plurality of bits and superimposed on the electric current or the voltage in the power line by the identification information transmitting device before the identification information.

Note that an arbitrary combination of the structural elements described above and those obtained by converting the expressions described in the present disclosure into devices, systems, methods, computer programs, and the like are also effective as embodiments of the present disclosure.

According to the present disclosure, it is possible to reduce false determination that may occur at the time of reading identification information superimposed on an electric current or a voltage in a power line.

### Brief Description of Drawings

[Fig. 1] Fig. 1 is a diagram illustrating an electric assisted bicycle with a battery pack attached thereto according to an exemplary embodiment.
[Fig. 2] Fig. 2 is a diagram for describing the outline of verification process example 1 for a battery pack attached to a vehicle.
[Fig. 3] Fig. 3 is a diagram illustrating configuration example 1 of a battery pack and a vehicle according to an exemplary embodiment.
[Fig. 4] Fig. 4 is a diagram for describing the outline of verification process example 2 for a battery pack attached to a vehicle.
[Fig. 5] Fig. 5 is a diagram illustrating configuration example 2 of a battery pack and a vehicle according to an exemplary embodiment.
[Fig. 6] Fig. 6 is a diagram illustrating one example of an electric current value measured by an identification information receiving device.
[Fig. 7] Fig. 7 is a diagram illustrating function blocks of an identification information receiving function according to an exemplary embodiment.
[Fig. 8] Fig. 8 is a diagram illustrating data format example 1 including a specific bit string and an ID bit string.
[Fig. 9] Fig. 9 is a diagram illustrating an image for calculating a determination threshold value when a 1/0 pulse is used for a specific bit string.
[Fig. 10] Fig. 10 is a diagram illustrating an image for determining ID when a 1/0 pulse is used for a specific bit string.
[Fig. 11] Fig. 11 is a diagram illustrating data format example 2 including a specific bit string and an ID bit string.
[Fig. 12] Fig. 12 is a diagram (No. 1) illustrating an image for calculating a determination threshold value when a pseudo-noise (PN) code is used for a specific bit string.
[Fig. 13] Fig. 13 is a diagram (No. 2) illustrating an image for calculating a determination threshold value when a PN code is used for a specific bit string.
[Fig. 14] Fig. 14 is a flowchart illustrating overall operation example 1 of an identification information receiving device according to an exemplary embodiment that is applied upon reception of ID.
[Fig. 15] Fig. 15 is a diagram illustrating a subroutine indicating detailed example 1 of the process of setting the first determination threshold value in Step S30 in Fig. 14.
[Fig. 16] Fig. 16 is a diagram illustrating a subroutine indicating detailed example 2 of the process of setting the first determination threshold value in Step S30 in Fig. 14.
[Fig. 17] Fig. 17 is a flowchart (No. 1) illustrating detailed process example 1 of Steps S50 to S70 in Fig. 14.
[Fig. 18] Fig. 18 is a flowchart (No. 2) illustrating detailed process example 1 of Steps S50 to S70 in Fig. 14.
[Fig. 19] Fig. 19 is a flowchart illustrating detailed process example 2 of Steps S50 to S70 in Fig. 14.
[Fig. 20] Fig. 20 is a flowchart illustrating overall operation example 2 of an identification information receiving device according to an exemplary embodiment that is applied upon reception of ID.
[Fig. 21] Fig. 21 is a diagram illustrating data format example 3 including an ID bit string that corresponds to overall operation example 2.
[Fig. 22] Fig. 22 is a flowchart illustrating overall operation example 3 of an identification information receiving device according to an exemplary embodiment that is applied upon reception of ID.

### Description of Embodiments

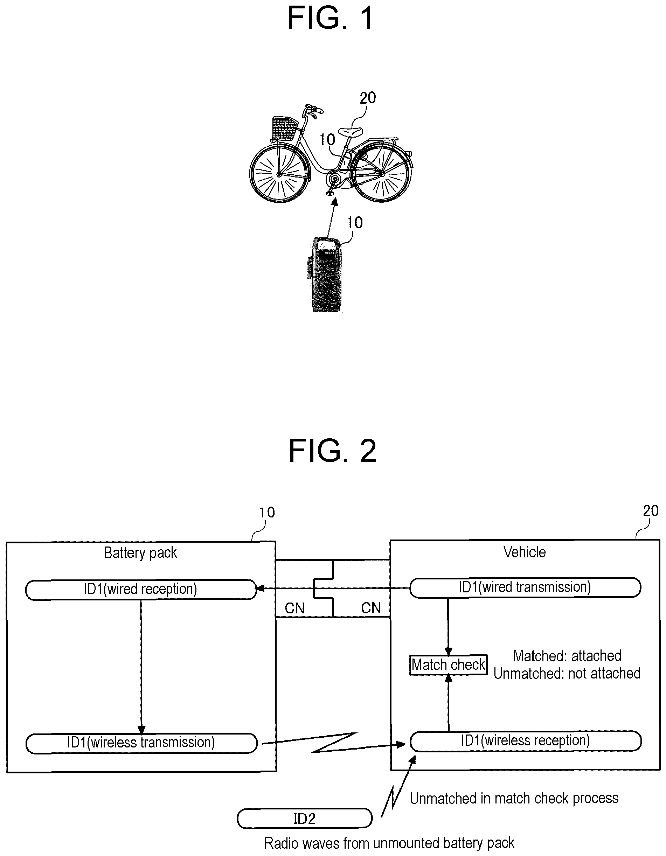

Fig. 1 is a diagram illustrating an electric assisted bicycle with a battery pack attached thereto according to an exemplary embodiment. Battery pack 10, which is a detachable, portable, replaceable battery pack 10, can be attached to a mounting slot of vehicle 20 or a charger (not illustrated in the drawings). Hereinafter, the exemplary embodiment assumes that vehicle 20 is an electric assisted bicycle.

Replaceable battery pack 10 is frequently attached to or detached from the mounting slot of vehicle 20 or the charger, and therefore a connector part of battery pack 10 is prone to wear and tear. Thus, in the present exemplary embodiment, battery pack 10 is provided with a wireless communication function to wirelessly transmit control signals. This allows for elimination of a terminal for communication lines from a connector of battery pack 10, leaving only a terminal for power lines.

Short-range wireless communication is used for the wireless communication between vehicle 20 and battery pack 10. As the short-range wireless communication, Bluetooth (registered trademark), Wi-Fi (registered trademark), infrared communication, or the like can be used.

Hereinafter, the present exemplary embodiment assumes that Bluetooth Low Energy (BLE) is used as the short-range wireless communication.

The BLE, which is one extended standard of Bluetooth, is a short-range wireless communication standard for low power consumption using the 2.4 GHz band. The BLE focuses on low power consumption allowing a device to operate for several years on a single button cell, meaning that the BLE is suitable for battery powered devices and can minimize the impact on the remaining capacity of battery pack 10. Furthermore, many modules for BLE communication are available in the market and thus are accessible at low cost.

When a typical Class 2 device is used, the BLE radio wave arrival range is approximately 10m. Therefore, a plurality of vehicles 20 and a plurality of battery packs 10 may be present in one BLE communication range. In this situation, there may be radio wave interference between vehicles systems, making the operation unstable. Vehicle 20 may be erroneously connected to battery pack 10 different from battery pack 10 attached thereto; in this situation, there is a possibility that battery pack 10 that is not attached to vehicle 20 will be erroneously controlled.

To address this issue, it is necessary to provide a system that ensures that battery pack 10 attached to vehicle 20 and battery pack 10 communicating with vehicle 20 are the same. In the present exemplary embodiment, using the identification information (ID), it is verified that battery pack 10 physically connected to vehicle 20 via wired communication and battery pack 10 connected to vehicle 20 via wireless communication are the same. This identification information (ID) may be identification information unique to each vehicle 20 or each battery pack 10 or may be temporary identification information. As the unique identification information, a Bluetooth device (BD) address or a medium access control (MAC) address may be used, for example.

Fig. 2 is a diagram for describing the outline of verification process example 1 for battery pack 10 attached to vehicle 20. When the connector of battery pack 10 and the connector of the mounting slot of vehicle 20 are connected, vehicle 20 transmits ID 1 to battery pack 10 via the wired communication. When receiving ID 1 via wired communication, battery pack 10 sends, via short-range wireless communication, an advertising packet (beacon packet) including ID 1 received and own battery pack ID. The advertising packet is a signal for notifying nearby devices of the presence of battery pack 10 via the short-range wireless communication.

When receiving the advertising packet, vehicle 20 checks ID 1 included in the advertising packet against ID 1 transmitted to battery pack 10 via the wired communication. When there is a match between these, vehicle 20 verifies that battery pack 10 attached thereto and the entity communicating therewith via the short-range wireless communication are the same. When there is no match between these, vehicle 20 determines that battery pack 10 attached thereto and the entity communicating therewith via the short-range wireless communication are not the same, and does not verify battery pack 10 communicating therewith. For example, when an advertising packet including ID 2 is received, battery pack 10 that is a source from which the advertising packet including ID 2 has been transmitted is not verified because ID 2 does not match ID 1 transmitted to battery pack 10 via the wired communication.

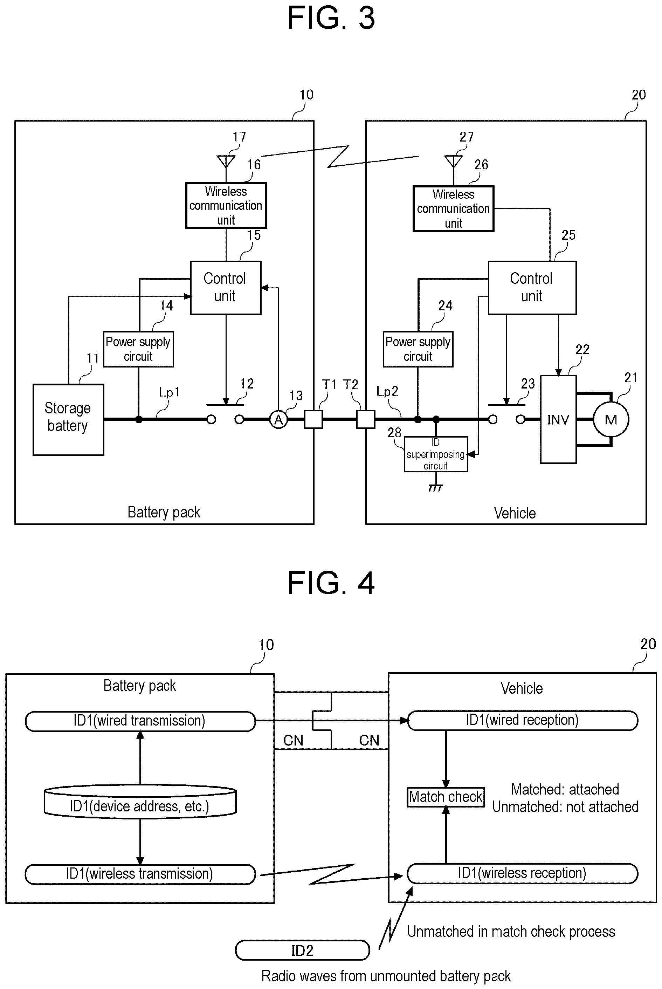

Fig. 3 is a diagram illustrating configuration example 1 of battery pack 10 and vehicle 20 according to the exemplary embodiment. Configuration example 1 illustrated in Fig. 3 corresponds to verification process example 1; in Fig. 3, structural elements needed for verification process example 1 are illustrated while structural elements irrelevant to verification process example 1 are omitted, as appropriate. In Fig. 3, it is assumed that vehicle 20 includes battery pack 10 attached thereto.

Battery pack 10 includes storage battery 11, first relay 12, first current sensor 13, first power supply circuit 14, first control unit 15, first wireless communication unit 16, first antenna 17, and power supply terminal T1. Vehicle 20 includes motor 21, inverter 22, second relay 23, second power supply circuit 24, second control unit 25, second wireless communication unit 26, second antenna 27, second ID superimposing circuit 28, and power receiving terminal T2. In the state where battery pack 10 is attached to vehicle 20, power supply terminal T1 and power receiving terminal T2 are in physical contact, and power line Lp1 in battery pack 10 and power line Lp2 in vehicle 20 are in a conducting state.

Storage battery 11 includes a plurality of cells connected in series or series/parallel. As the cells, lithium-ion battery cells, nickel-hydrogen battery cells, lead battery cells, or the like can be used. The following example herein assumes that lithium-ion battery cells (with a nominal voltage of 3.6 V to 3.7 V) are used.

The number of cells connected in series is determined according to a drive voltage for motor 21 of vehicle 20.

First relay 12 is inserted into power line Lp1 that connects storage battery 11 and power supply terminal T1. Note that other kinds of switches such as a semiconductor switch may be used in place of the relay.

First current sensor 13 measures an electric current flowing through power line Lp1 in battery pack 10 and outputs the electric current measurement value to first control unit 15. First current sensor 13 is formed by combining a current transformer (CT) sensor and a current measurement circuit, for example. The current measurement circuit outputs, to first control unit 15, an electric current measurement value that indicates an electric current flowing to a coil wound on the magnetic core of the CT sensor extracted as a voltage using a shunt resistor. Note that other methods using a Hall element, a Rogowski coil, or the like in place of the CT sensor may also be applied.

First power supply circuit 14 is a DC/DC converter that steps down the voltage of storage battery 11 and generates a power supply voltage (for example, approximately 3.3 V to 5 V) for first control unit 15. First power supply circuit 14 may be formed of a switching regulator or may be formed of a linear regulator.

First control unit 15 is a microcontroller that controls entire battery pack 10. First control unit 15 monitors the state of storage battery 11 (specifically, the voltage, the electric current, and the temperature at each cell included in storage battery 11). On the basis of the monitoring data, first control unit 15 estimates the state of charge (SOC), the full charge capacity (FCC), and the state of health (SOH) of each cell included in storage battery 11. Furthermore, when an overvoltage, an undervoltage, an overcurrent, a high-temperature anomaly, or a low-temperature anomaly occurs in a cell included in storage battery 11, first control unit 15 turns off first relay 12 to protect the cell.

First wireless communication unit 16 performs a short-range wireless communication process. In the present exemplary embodiment, first wireless communication unit 16 is formed of a BLE module, and first antenna 17 is formed of a pattern antenna or a chip antenna embedded in the BLE module. First wireless communication unit 16 outputs, to first control unit 15, data received via the short-range wireless communication, and transmits, via the short-range wireless communication, data that is input from first control unit 15.

In the present exemplary embodiment, vehicle 20 includes a three-phase alternating-current motor as motor 21 for driving. Inverter 22 converts direct-current power supplied from battery pack 10 into alternating-current power and supplies the alternating-current power to motor 21 during power running. During regeneration, the alternating-current power supplied from motor 21 is converted into direct-current power and supplied to battery pack 10. Motor 21 rotates according to the alternating-current power supplied from inverter 22 during power running. During regeneration, rotational energy generated as a result of a reduction in speed is converted into alternating-current power and supplied to inverter 22.

Second relay 23 is inserted into power line Lp2 that connects inverter 22 and power receiving terminal T2. Note that other kinds of switches such as a semiconductor switch may be used in place of the relay.

Second power supply circuit 24 is a DC/DC converter that steps down the voltage supplied from storage battery 11 in battery pack 10 attached to vehicle 20 and generates a power supply voltage (for example, approximately 3.3 V to 5 V) for second control unit 25. Second power supply circuit 24 may be formed of a switching regulator or may be formed of a linear regulator. In the present exemplary embodiment, vehicle 20 does not include its own battery (for example, a lead-acid battery) for generating control power supply. Therefore, the control power supply needs to be generated from the power supply for driving that is supplied from storage battery 11 in attached battery pack 10.

Second control unit 25 is a microcontroller that controls entire vehicle 20. Second wireless communication unit 26 performs a short-range wireless communication process. In the present exemplary embodiment, second wireless communication unit 26 can be formed of a BLE module, and second antenna 27 can be formed of a pattern antenna or a chip antenna embedded in the BLE module. Second wireless communication unit 26 outputs, to second control unit 25, data received via the short-range wireless communication, and transmits, via the short-range wireless communication, data that is input from second control unit 25.

Second ID superimposing circuit 28 superimposes ID on the electric current flowing to power line Lp2. The ID is defined by a plurality of bits each of which is represented using a binary current. When the power supply for second control unit 25 comes from storage battery 11 in battery pack 10 instead of the own battery embedded in vehicle 20, energization and de-energization of the electric current flowing from storage battery 11 to vehicle 20 cannot be assigned to the binary current representing each bit of the ID. Therefore, the binary current representing each bit needs to be set to two electric current values other than zero.

Second ID superimposing circuit 28 includes: two loads having different resistance values; and one or more switches for selecting one of the two loads or placing the two loads in a non-conducting state. Alternatively, second ID superimposing circuit 28 may be configured to include: a variable load capable of switching between two resistance values; and one or more switches for switching the resistance value of the variable load or placing the variable load in a non-conducting state.

In the state where second relay 23 is OFF, an electric current flowing to power line Lp2 substantially depends on electric current consumption of second control unit 25. In the state where second relay 23 is OFF, second control unit 25 sets ID in second ID superimposing circuit 28, and second ID superimposing circuit 28 superimposes the bit "1" of the ID on the electric current by placing one of the two loads that has a smaller resistance value in a conducting state, and superimposes the bit "0" of the ID on the electric current by placing one of the two loads that has a larger resistance value in a conducting state. Thus, the value of the electric current to be drawn into vehicle 20 changes according to each bit of the ID. First current sensor 13 in battery pack 10 measures the electric current flowing to power line Lp1 and outputs the electric current measurement to first control unit 15.

Fig. 4 is a diagram for describing the outline of verification process example 2 for battery pack 10 attached to vehicle 20. When the connector of battery pack 10 and the connector of the mounting slot of vehicle 20 are connected, battery pack 10 transmits ID 1 to vehicle 20 via wired communication. At the same time, battery pack 10 sends an advertising packet including ID 1 via short-range wireless communication.

When receiving the advertising packet, vehicle 20 checks ID 1 included in the advertising packet against ID 1 received via the wired communication. When there is a match between these, vehicle 20 verifies that battery pack 10 attached thereto and the entity communicating therewith via the short-range wireless communication are the same. When there is no match between these, vehicle 20 determines that battery pack 10 attached thereto and the entity communicating therewith via the short-range wireless communication are not the same, and does not verify battery pack 10 communicating therewith. For example, when an advertising packet including ID 2 is received, battery pack 10 that is a source from which the advertising packet including ID 2 has been transmitted is not verified because ID 2 does not match ID 1 received via the wired communication.

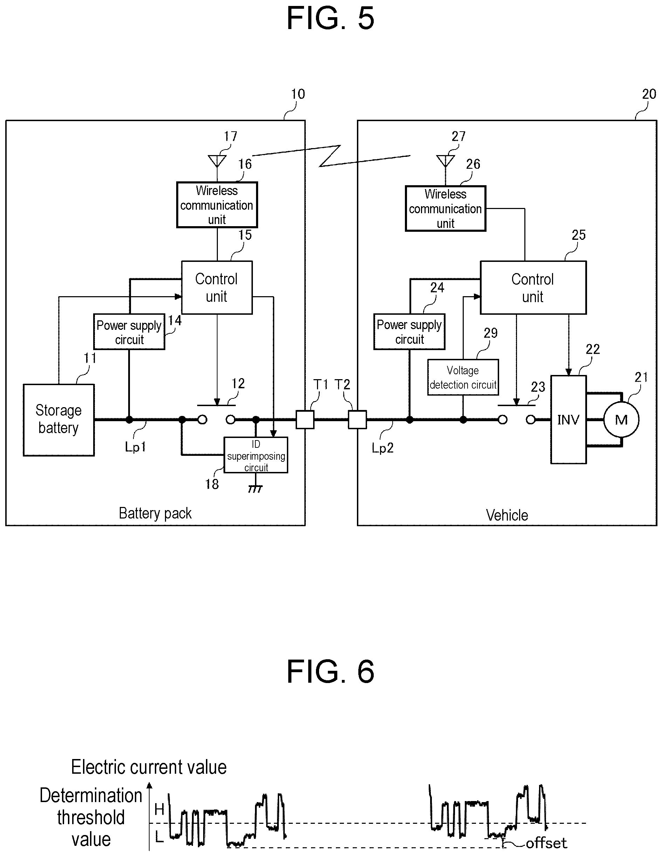

Fig. 5 is a diagram illustrating configuration example 2 of battery pack 10 and vehicle 20 according to the exemplary embodiment. Configuration example 2 illustrated in Fig. 5 corresponds to verification process example 2; in Fig. 5, structural elements needed for verification process example 2 are illustrated while structural elements irrelevant to verification process example 2 are omitted, as appropriate. In configuration example 1, the ID is superimposed on the electric current flowing to the power line. In configuration example, 2, the ID is superimposed on the voltage in the power line.

In configuration example 2 illustrated in Fig. 5, first ID superimposing circuit 18 is provided at the battery pack 10 end, and voltage detection circuit 29 is provided at the vehicle 20 end, as compared to configuration example 1 illustrated in Fig. 3. First ID superimposing circuit 18 includes an adder circuit that uses an operational amplifier, for example. Using the voltage of storage battery 11 as a power supply voltage, the operational amplifier adds, to a base voltage lower than the power supply voltage, an **ID** voltage supplied from first control unit 15, and outputs the resultant voltage to power line Lp1. Thus, the value of the voltage to be supplied to vehicle 20 changes according to each bit of the ID.

Voltage detection circuit 29 at the vehicle 20 end measures the voltage in power line Lp2 and outputs the voltage measurement value to second control unit 25. Voltage detection circuit 29 is formed of a resistance divider circuit, for example; the divided voltage is input to an analog input port of second control unit 25.

**In** configuration example 1 illustrated in Fig. 3, the **ID** is transmitted from vehicle 20 to battery pack 10, meaning that vehicle 20 is an identification information transmitting device and battery pack 10 is an identification information receiving device. **In** contrast, in configuration example 2 illustrated in Fig. 5, the **ID** is transmitted from battery pack 10 to vehicle 20, meaning that battery pack 10 is an identification information transmitting device and vehicle 20 is an identification information receiving device. The following will describe the identification information receiving device in configuration example 1 in which the electric current superimposing method is applied.

Fig. 6 is a diagram illustrating one example of the electric current value measured by the identification information receiving device. The left figure indicates an electric current value with no offset added thereto, and the right figure indicates an electric current value with an offset added thereto. The identification information receiving device determines the bit to be "1" when the electric current measurement value is greater than or equal to the determination threshold value, and determines the bit to be "0" when the electric current measurement value is less than the determination threshold value. As one example, the determination threshold value may be set to 50 mA, the expected low-level electric current value may be set to 30 mA, and the expected high-level electric current value may be set to 70 mA.

At this time, there is a possibility that an offset may be added to the electric current measurement value due to variations in the characteristics of components or due to changes in electric current consumption, for example. Variations occur in the characteristics of components due to at least one of individual differences, temperature fluctuations, and changes over time. Changes in the electric current consumption of the identification information transmitting device (vehicle 20) occur, for example, when some background process or event process (for example, a software update process) starts in second control unit 25 (microcomputer) during a verification process that uses second control unit 25. Furthermore, changes in the electric current consumption of the identification information transmitting device (vehicle 20) occur due also to changes in structure such as turn-on of a light.

With such changes in the system status, the system configuration, and the like, the electric current flowing to the power line increases when the electric current consumption of the identification information transmitting device increases. In other words, an offset is added to the electric current flowing to the power line. This offset may lead to false bit determination of the ID superimposed on the electric current flowing to the power line. The following will describe a method in which the determination threshold value is adaptively changed according to situations so that false bit determination of the ID is prevented, leading to improved system reliability.

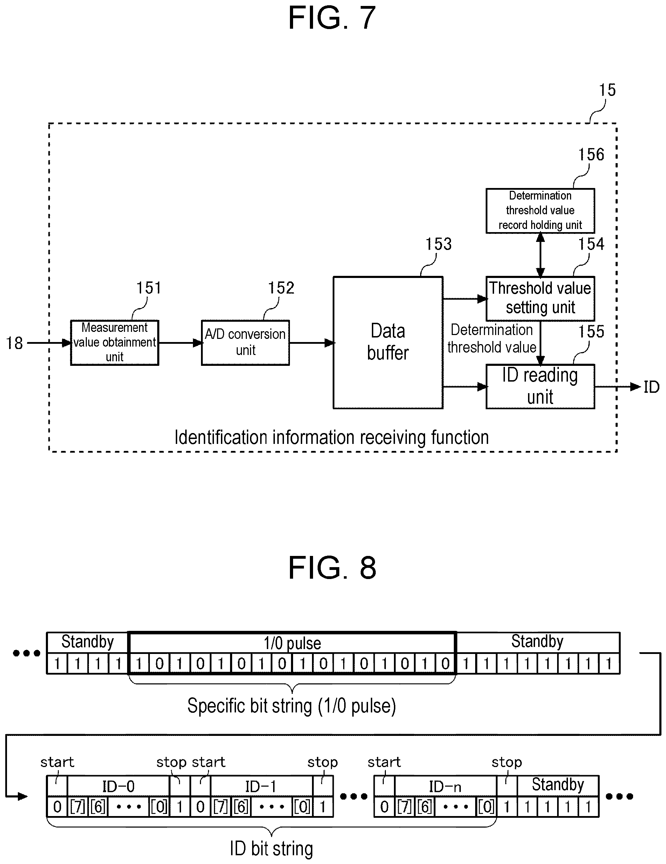

Fig. 7 is a diagram illustrating function blocks of an identification information receiving function according to the exemplary embodiment. The present exemplary embodiment assumes that first control unit 15 (microcomputer) includes the identification information receiving function.

First control unit 15 includes measurement value obtainment unit 151, A/D conversion unit 152, data buffer 153, threshold value setting unit 154, ID reading unit 155, and determination threshold value record holding unit 156.

Measurement value obtainment unit 151 obtains, from first current sensor 13, the measurement value of the electric current flowing to the power line. The electric current measurement value is input as an analog voltage corresponding to the electric current value. In the present exemplary embodiment, measurement value obtainment unit 151 corresponds to an analog input port of first control unit 15 (microcomputer).

A/D conversion unit 152 converts, into a digital electric current measurement value, the electric current measurement value defined by the analog voltage obtained by measurement value obtainment unit 151. For example, A/D conversion unit 152 converts the analog voltage at each sampling timing into a digital value at 10-12 bit resolution. A/D conversion unit 152 is capable of oversampling at a sampling rate that is 8 or 16 times greater than the communication speed of ID. For example, when the communication speed of ID is 9,600 bps, sampling at 76.8 kHz or 153.6 k Hz is possible.

Note that the A/D conversion unit may be provided outside first control unit 15 (microcomputer). In this situation, measurement value obtainment unit 151 obtains a digital electric current measurement value resulting from the A/D conversion. Measurement value obtainment unit 151 corresponds to a digital input port of first control unit 15 (microcomputer).

Data buffer 153 temporarily holds the digital electric current measurement values sequentially input by A/D conversion unit 152. In the present embodiment, data buffer 153 corresponds to a buffer register included in first control unit 15 (microcomputer).

Threshold value setting unit 154 sets a determination threshold value on the basis of an initial threshold value (other than 0) and an electric current measurement value corresponding to each bit of threshold value verification information (defined by a plurality of bits) that is superimposed on the electric current flowing to the power line before the ID information.

Fig. 8 is a diagram illustrating data format example 1 including a specific bit string and an ID bit string.

In data format example 1, a 16-bit 1/0 pulse in which alternate "1" and "0" are repeated is used as a specific bit string representing the threshold value verification information. In data format example 1, "1" is continuously transmitted during standby. The ID bit string representing the ID information includes ID including n words (where n is a natural number). Each word includes: a start bit consisting of one bit; data bits consisting of eight bits; and a stop bit consisting of one bit. The start bit is defined by "0," and the stop bit is defined by "1." For example, when the ID bit string includes 10 words, a bit string stores a total of 100 bits (= (1 + 8 + 1) × 10).

Threshold value setting unit 154 compares the initial threshold value and the electric current measurement value corresponding to each bit of the specific bit string, and determines the electric current measurement value greater than or equal to the initial threshold value to be high-level and the electric current measurement value less than the initial threshold value to be low-level. When the electric current measurement value in each bit is oversampled, 8 or 16 electric current measurement values are generated for each bit.

Threshold value setting unit 154 calculates each of a representative value (for example, a mean, a median, or a mode) of the plurality of electric current measurement values determined to be high-level and a representative value (for example, a mean, a median, or a mode) of the plurality of electric current measurement values determined to be low-level. Threshold value setting unit 154 sets the determination threshold value to the intermediate value between the two representative values. The intermediate value between the two representative values may be the mean of the two representative values or may be a value obtained by adding a positive or negative margin to said mean. The positive or negative margin may be determined according to the balance ration between the number of electric current measurement values determined to be high-level and the number of electric current measurement value determined to be low-level. The relationship between the balance ratio and the margin can be derived in advance by an experiment or a simulation.

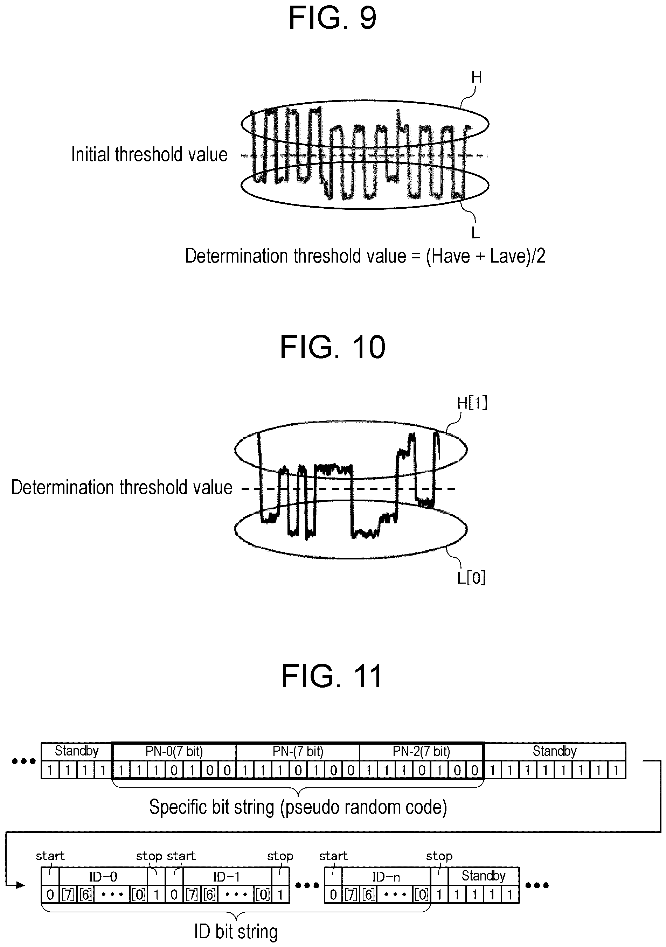

Fig. 9 is a diagram illustrating an image for calculating the determination threshold value when a 1/0 pulse is used for the specific bit string. Threshold value setting unit 154 calculates the mean of the electric current measurement values in the group determined to be high-level and the mean of the electric current measurement values in the group determined to be low-level, and sets the determined threshold value to the mean of the two means ((Have + Lave) / 2). In the present exemplary embodiment, the binary current representing the bit "1" and the bit "0" is set to a value other than zero, and therefore the determination threshold value is also set to a value other than zero.

Fig. 7 will be referred to again below. ID reading unit 155 reads, as binary data, the ID bit string superimposed on the electric current flowing to the power line, by determining whether the electric current measurement value corresponding to each bit of the ID bit string is greater or less than the determination threshold value. The following example assumes that when the electric current measurement value is greater than or equal to the determination threshold value, the bit is determined to be "1," and when the electric current measurement value is less than the determination threshold value, the bit is determined to be "0." Note that when the electric current measurement value is greater than the determination threshold value, the bit may be determined to be "1," and when the electric current measurement value is less than or equal to the determination threshold value, the bit may be determined to be "0."

When the electric current measurement value in each bit is oversampled data, ID reading unit 155 determines, for example, that out of the determined values of the 8 or 16 electric current measurement values corresponding to each bit, the value of the bit more often determined to be "1" is determined to be "1," and the value of the bit more often determined to be "0" is determined to be "0." Alternatively, ID reading unit 155 may calculate the mean of 8 or 16 electric current measurement values corresponding to each bit, compare the mean of the electric current measurement values corresponding to each bit to the determination threshold value, and determine the value of the bit.

Fig. 10 is a diagram illustrating an image for determining ID when a 1/0 pulse is used for the specific bit string. By determining that when the electric measurement value corresponding to each bit of the ID bit string is greater than or equal to the determination threshold value, the bit is at the high level "1" and when the electric measurement value corresponding to each bit of the ID bit string is less than the determination threshold value, the bit is at the low level "0," ID reading unit 155 reads the ID information superimposed on the electric current.

Fig. 11 is a diagram illustrating data format example 2 including a specific bit string and an ID bit string. In data format example 2, a pseudo random noise (PN) code is used as the specific bit string. The PN code (pseudo random code) is generated using a linear feedback shift register (LFSR), for example. The generated PN code is written in advance in both the firmware of second control unit 25 in the identification information transmitting device and the firmware of first control unit 15 in the identification information receiving device. In the example illustrated in Fig. 11, one PN code defined by seven bits, "1110100," is continuously transmitted three times. The configuration of the ID bit string is substantially the same as that in data format example 1 illustrated in Fig. 8.

Threshold value setting unit 154 holds, in advance, converted threshold value verification information (converted PN code) obtained by converting "0" in the specific bit string (PN code) representing the threshold value verification information into a negative value and setting a value corresponding to "1" in the specific bit string and a value corresponding to "0" in the specific bit string to have equal absolute values. The following example assumes that the converted threshold value verification information is generated by converting "1" into "+1" and converting "0" into "-1." Note that it is also possible to convert "1" into "+2" and convert "0" into "-2." Threshold value setting unit 154 sequentially calculates a difference value by subtracting the initial threshold value from the electric current measurement value corresponding to each bit in the specific bit string (PN code) superimposed on the electric current flowing to the power line. Threshold value setting unit 154 multiplies, for each digit, the converted threshold value verification information (converted PN code) and a difference value sequence in which the calculated difference values are arranged. Threshold value setting unit 154 calculates sum ΣS of products in the respective digits. When the electric current measurement value in each bit is oversampled, 8 or 16 electric current measurement values are generated for each bit, and 8 or 16 products are generated for each digit of the converted PN code.

On the basis of sum ΣS of products in the number of digits of the converted PN code (in the example illustrated in Fig. 11, seven digits), threshold value setting unit 154 specifies a difference value sequence in a section in which the degree of correlation with the converted PN code is highest in the continuous difference value sequence. Threshold value setting unit 154 calculates each of a representative value (for example, the mean, the median, or the mode) of positive values included in the specified difference value sequence and a representative value (for example, the mean, the median, or the mode) of negative values included in the specified difference value sequence, and sets the determination threshold value to the intermediate value between the two representative values. The intermediate value between the two representative values may be the mean of the two representative values or may be a value obtained by adding a positive or negative margin to said mean. The method for reading the ID information by ID reading unit 155 using the determination threshold value is substantially the same as the method indicated in the description of data format example 1.

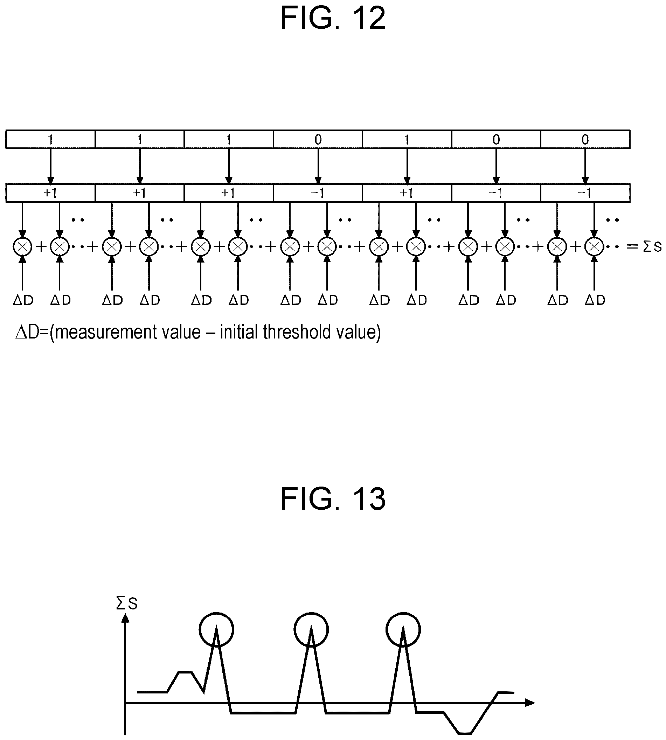

Fig. 12 is a diagram (No. 1) illustrating an image for calculating the determination threshold value when the PN code is used for the specific bit string. Threshold value setting unit 154 converts a 7-bit PN code, "1110100," into a converted 7-digit PN code, "+1+1+1-1+1-1-1." Threshold value setting unit 154 calculates difference value ΔD by subtracting the initial threshold value from the electric current measurement value corresponding to each bit of the PN code. The converted PN code indicates positive and negative expected values in the respective digits of 7-digit difference value ΔD to be specified from the difference value sequence continuously generated. Threshold value setting unit 154 multiplies, for each digit, the difference value sequence in which 7-digit difference values ΔD are arranged and the converted 7-digit difference value PN code. Threshold value setting unit 154 calculates sum ΣS of products in the seven digits.

Fig. 13 is a diagram (No. 2) illustrating an image for calculating the determination threshold value when the PN code is used for the specific bit string. Threshold value setting unit 154 continuously generates sum ΣS on the basis of the converted 7-digit PN code and 7-digit difference value ΔD extracted in a 7-digit detection window from the difference value sequence continuously generated upon reception of the PN code. Fig. 13 illustrates an example of how sum ΣS transitions. The value of sum ΣS increases with an increase in the match rate between the plus-minus sign for each digit of 7-digit difference value ΔD to the plus-minus sign for the corresponding digit of the converted 7-digit PN code.

In Fig. 13, there are three sharp peaks in time-series data of sum ΣS. The peak point in the time-series data of sum ΣS indicates timing at which the degree of correlation between the plus-minus sign for each digit of the 7-digit difference value sequence and the plus-minus sign for the corresponding digit of the converted 7-digit PN code is highest. Threshold value setting unit 154 reads, from data buffer 153, the 7-digit difference value sequence corresponding to the timing at which the degree of autocorrelation is highest, and calculates a determination threshold value on the basis of the read 7-digit difference value sequence.

In data format example 1 illustrated in Fig. 8 and data format example 2 illustrated in Fig. 11, a plurality of ID bit strings are arranged. This means that the identification information transmitting device superimposes the plurality of ID bit strings on the electric current flowing to the power line. In this situation, during the course of communication of the plurality of ID bit strings, an offset may be added to the electric current flowing to the power line or the offset may fluctuate. In view of this, a system is introduced that dynamically updates the determination threshold value according to the offset added to the electric current flowing to the power line.

Threshold value setting unit 154 sets the initial value of the determination threshold value on the basis of the initial threshold value and the electric current measurement value corresponding to each bit of the specific bit string superimposed on the electric current flowing to the power line. Subsequently, threshold value setting unit 154 updates the determination threshold value on the basis of the latest determination threshold value and the electric current measurement value corresponding to each bit of the ID bit string superimposed on the electric current flowing to the power line. Specifically, threshold value setting unit 154 compares the electric current measurement value corresponding to each bit of the ID bit string to the latest determination threshold value, and calculates each of the respective value of the electric current measurement values greater than or equal to the latest determination threshold value and the representative value of the electric current measurement values less than the latest determination threshold value.

Threshold value setting unit 154 sets the determination threshold value to the intermediate value between the two representative values as an updated determination threshold value.

ID reading unit 155 may read the ID bit string using the updated determination threshold value that has been set on the basis of said ID bit stream or may read the ID bit string using the determination threshold value that has not yet been updated (the determination threshold value that has been set on the basis of the immediately preceding ID bit string).

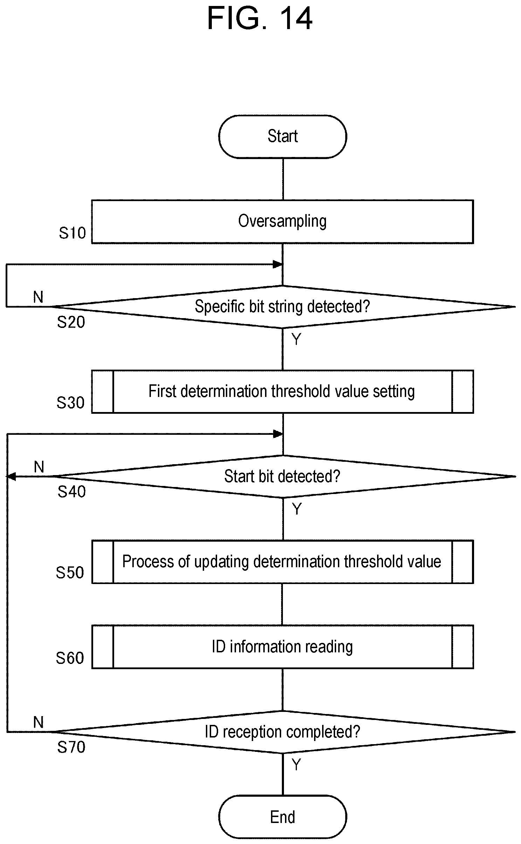

Fig. 14 is a flowchart illustrating overall operation example 1 of the identification information receiving device according to the exemplary embodiment that is applied upon reception of the ID. The identification information receiving device sets A/D conversion unit 152 in an oversampling mode upon reception of the ID information (S10). When detecting the specific bit string from the bit string superimposed on the electric current that is being received (Y in S20), threshold value setting unit 154 performs the process of setting the first determination threshold value (S30).

When detecting a start bit of the ID bit string (Y in S40), threshold value setting unit 154 performs the process of updating the determination threshold value (S50). ID reading unit 155 reads the ID information using the updated determination threshold value or the immediately preceding determination threshold value that has not yet been updated (S60). The processes in Steps S40 to S60 are repeatedly performed (N in S70) until the reception of the bit string including the ID information superimposed on the electric current is completed (Y in S70).

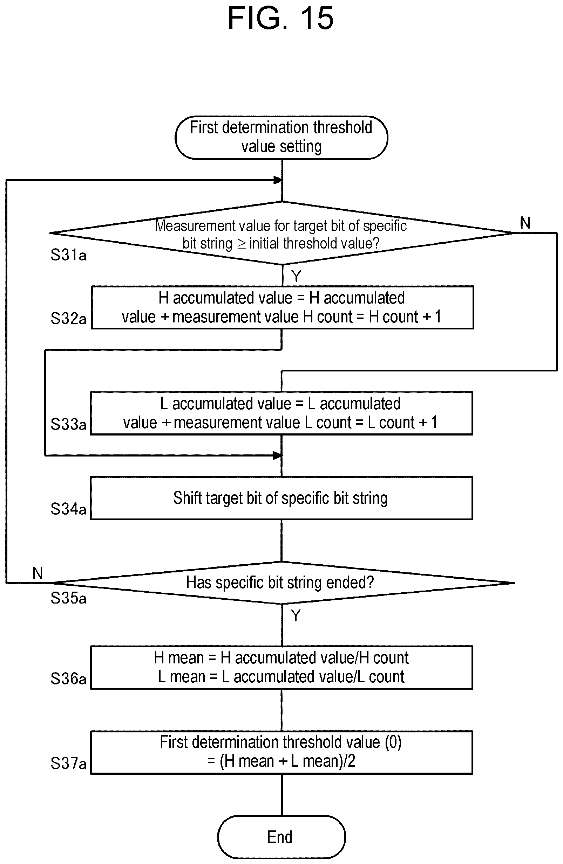

Fig. 15 is a diagram illustrating a subroutine indicating detailed example 1 of the process of setting the first determination threshold value in Step S30 in Fig. 14. Detailed example 1 corresponds to an example in which a 1/0 pulse is used for the specific bit string. Threshold value setting unit 154 compares the electric current measurement value corresponding to a target bit of the specific bit string to the initial threshold value (S31a). The target bit of the specific bit string transitions from the most significant bit to the least significant bit.

When the electric current measurement value corresponding to the target bit is greater than or equal to the initial threshold value (Y in S31a), threshold value setting unit 154 adds said electric current measurement value to an H accumulated value and increments an H count (S32a). When the electric current measurement value corresponding to the target bit is less than the initial threshold value (N in S31a), threshold value setting unit 154 adds said electric current measurement value to an L accumulated value and increments an L count (S33a). Note that the initial values of the H accumulated value, the L accumulated value, the H count, and the L count are zero.

Threshold value setting unit 154 shifts the target bit of the specific bit string (S34a). Threshold value setting unit 154 determines whether the adding process for every bit of the specific bit string has been completed (S35a). When the adding process for every bit has not been completed (N in S35a), the processing transitions to Step S31a to perform the adding process for the next target bit.

When the adding process for every bit of the specific bit string has been completed (Y in S35a), threshold value setting unit 154 calculates an H mean by dividing the H accumulated value by the H count, and calculates an L mean by dividing the L accumulated value by the L count (S36a). Threshold value setting unit 154 calculates the first determination threshold value (0) by dividing the sum of the H mean and the L mean by 2 (S37a).

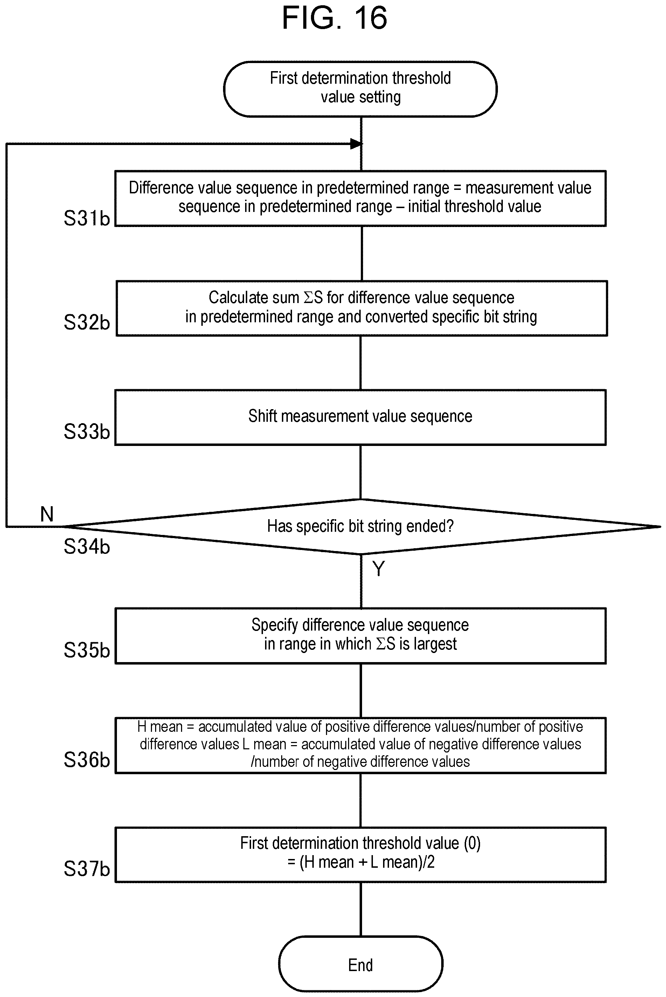

Fig. 16 is a diagram illustrating a subroutine indicating detailed example 2 of the process of setting the first determination threshold value in Step S30 in Fig. 14. Detailed example 2 corresponds to an example in which a PN code is used for the specific bit string. Threshold value setting unit 154 subtracts the initial threshold value on a per electric current measurement value basis from the electric current measurement value sequence in a predetermined range that is included in the specific bit string, and thereby generates a difference value sequence in the predetermined range (31b). Threshold value setting unit 154 multiplies, for each digit, the difference value sequence in the predetermined range and the converted specific bit string (converted PN code), and calculates sum ΣS of products in the respective digits (32b).

Threshold value setting unit 154 shifts the electric current measurement value sequence to update the electric current measurement value sequence for which sum ΣS is to be calculated (S33b). Threshold value setting unit 154 determines whether the processing on the entire section of the specific bit string has been completed (S34b). When the processing on the entire section of the specific bit string has not been completed (N in S34b), the processing transitions to Step S31b to perform the process of calculating sum ΣS for the electric current measurement value sequence in the next predetermined range.

When the processing on the entire section of the specific bit string has been completed (Y in S34b), threshold value setting unit 154 specifies a difference value sequence in a range in which sum ΣS is largest (S35b). Threshold value setting unit 154 calculates an H mean by accumulating positive difference values included in the specified difference value sequence and dividing the accumulated positive difference values by the number of positive difference values. Similarly, threshold value setting unit 154 calculates an L mean by accumulating negative difference values included in the specified difference value sequence and dividing the accumulated negative difference values by the number of negative difference values (S36b). Threshold value setting unit 154 calculates the first determination threshold value (0) by dividing the sum of the H mean and the L mean by 2 (S37b).

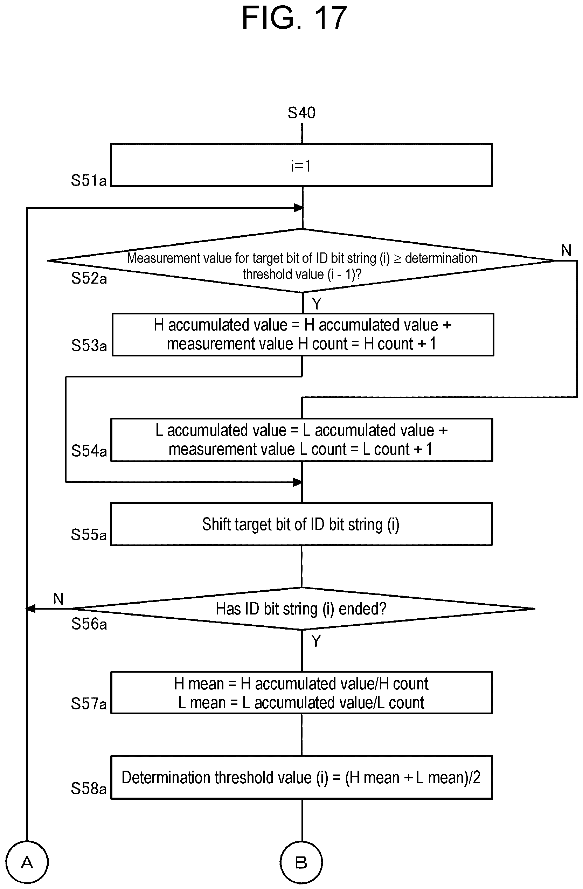

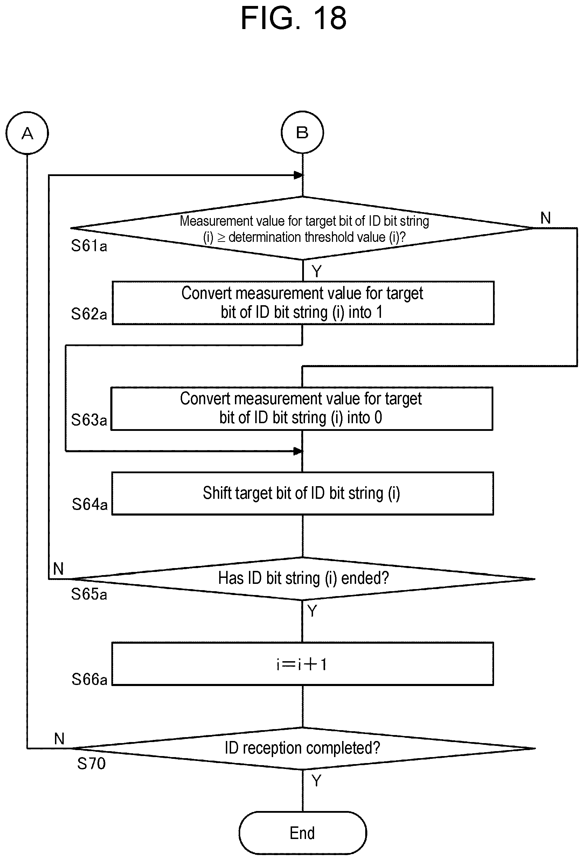

Fig. 17 is a flowchart (No. 1) illustrating detailed process example 1 of Steps S50 to S70 in Fig. 14. Fig. 18 is a flowchart (No. 2) illustrating detailed process example 1 of Steps S50 to S70 in Fig. 14. In Fig. 17, threshold value setting unit 154 sets the initial value of parameter i to 1 (S51a). Threshold value setting unit 154 compares the electric current measurement value corresponding to a target bit of ID bit string (i) to threshold value (i - 1) (S52a). The target bit of ID bit string (i) transitions from the most significant bit to the least significant bit.

When the electric current measurement value corresponding to the target bit is greater than or equal to a determination threshold value (i - 1) (Y in S52a), threshold value setting unit 154 adds said electric current measurement value to the H accumulated value and increments the H count (S53a). When the electric current measurement value corresponding to the target bit is less than the determination threshold value (i - 1) (N in S52a), threshold value setting unit 154 adds said electric current measurement value to the L accumulated value and increments the L count (S54a). Note that the initial values of the H accumulated value, the L accumulated value, the H count, and the L count are zero.

Threshold value setting unit 154 shifts the target bit of ID bit string (i) (S55a). Threshold value setting unit 154 determines whether the adding process for every bit of ID bit string (i) has been completed (S56a). When the adding process for every bit has not been completed (N in S56a), the processing transitions to Step S52a to perform the adding process for the next target bit.

When the adding process for every bit of ID bit string (i) has been completed (Y in S56a), threshold value setting unit 154 calculates an H mean by dividing the H accumulated value by the H count, and calculates an L mean by dividing the L accumulated value by the L count (S57a). Threshold value setting unit 154 calculates a determination threshold value (i) by dividing the sum of the H mean and the L mean by 2 (S58a).

The process transitions to Fig. 18. ID reading unit 155 compares the electric current measurement value corresponding to the target bit of ID bit string (i) to the determination threshold value (i) (S61a). When the electric current measurement value corresponding to the target bit is greater than or equal to the determination threshold value (i) (Y in S61a), ID reading unit 155 converts said electric current measurement value into "1" (S62a). When the electric current measurement value corresponding to the target bit is less than the determination threshold value (i) (N in S61a), ID reading unit 155 converts said electric current measurement value into "0" (S63a).

ID reading unit 155 shifts the target bit of ID bit string (i) (S64a). Threshold value setting unit 154 determines whether the conversion process for every bit of ID bit string (i) has been completed (S65a). When the conversion process for every bit has not been completed (N in S65a), the processing transitions to Step S61a to perform the conversion process for the next target bit.

When the conversion process for every bit of ID bit string (i) has been completed (Y in S65a), threshold value setting unit 154 increments parameter i (S66a). The processes in Steps S52a to S66a are repeatedly performed (N in S70) until the reception of the bit string including the ID information superimposed on the electric current is completed (Y in S70).

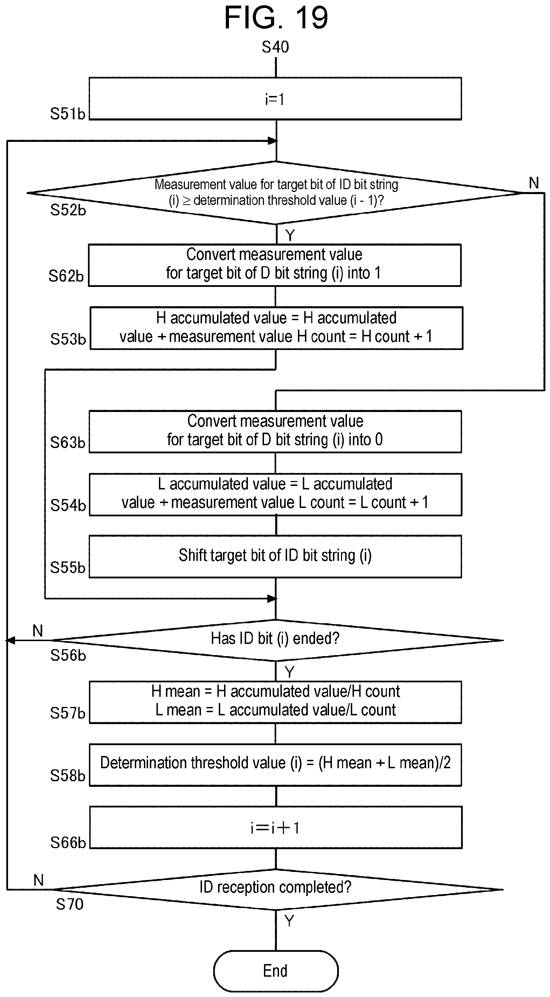

Fig. 19 is a flowchart illustrating detailed process example 2 of Steps S50 to S70 in Fig. 14. Threshold value setting unit 154 sets the initial value of parameter i to 1 (S51b). Threshold value setting unit 154 compares the electric current measurement value corresponding to the target bit of ID bit string (i) to the determination threshold value (i - 1) (S52b). The target bit of ID bit string (i) transitions from the most significant bit to the least significant bit.

When the electric current measurement value corresponding to the target bit is greater than or equal to the determination threshold value (i - 1) (Y in S52b), ID reading unit 155 converts said electric current measurement value into "1" (S62b). Threshold value setting unit 154 adds said electric current measurement value to the H accumulated value and increments the H count (S53b). When the electric current measurement value corresponding to the target bit is less than the determination threshold value (i - 1) (N in S52b), ID reading unit 155 converts said electric current measurement value into "0" (S63b).

Threshold value setting unit 154 adds said electric current measurement value to the L accumulated value and increments the L count (S54b). Note that the initial values of the H accumulated value, the L accumulated value, the H count, and the L count are zero.

Threshold value setting unit 154 shifts the target bit of ID bit string (i) (S55b). Threshold value setting unit 154 determines whether the conversion process and the adding process for every bit of ID bit string (i) have been completed (S56b). When the conversion process and the adding process for every bit have not been completed (N in S56b), the processing transitions to Step S52b to perform the conversion process and the adding process for the next target bit.

When the conversion process and the adding process for every bit of ID bit string (i) have been completed (Y in S56b), threshold value setting unit 154 calculates an H mean by dividing the H accumulated value by the H count, and calculates an L mean by dividing the L accumulated value by the L count (S57b). Threshold value setting unit 154 calculates the determination threshold value (i) by dividing the sum of the H mean and the L mean by 2 (S58b). Threshold value setting unit 154 increments parameter i (S66b). The processes in Steps S52b to S66b are repeatedly performed (N in S70) until the reception of the bit string including the ID information superimposed on the electric current is completed (Y in S70).

Comparison between the processes of updating the determination threshold value (S50) and the processes of reading the ID information (S60) in process example 1 and process example 2 shows that in process example 1, the reliability of the determination threshold value is higher and thus, the accuracy of determining ID is higher. In process example 2, it is not necessary to perform the determination threshold value generation process and the ID determination process separately in a redundant manner for each ID bit string and thus, the amount of computation can be reduced.

The initial threshold value to be used in the process of setting the first determination threshold value may be a fixed value or may be a variable value that is dynamically updated. In a design in which the variable value is used, threshold value setting unit 154 accumulates, in determination threshold value record holding unit 156, records of the determination threshold value generated upon reception of ID. The determination threshold value to be accumulated as a record may be the last determination threshold value generated upon reception of the current ID or may be all determination threshold values generated upon reception of the current ID. A representative value of all the determination threshold values generated upon reception of the current ID may also be accumulated.

Upon reception of new ID, threshold value setting unit 154 sets an initial threshold value on the basis of at least one determination threshold value held in determination threshold value record holding unit 156. Threshold value setting unit 154 may set the initial threshold value to the last determination threshold value accumulated in determination threshold value record holding unit 156, for example. Alternatively, threshold value setting unit 154 may set the initial threshold value to a representative value (for example, the mean, the median, and the mode) of all determination threshold values accumulated in determination threshold value record holding unit 156.

Threshold value setting unit 154 may accumulate the determination threshold value generated upon reception of ID in determination threshold value record holding unit 156 together with the temperature inside the identification information receiving device. Determination threshold value record holding unit 156 holds records of the determination threshold value on a per temperature section basis. Upon reception of new ID, threshold value setting unit 154 may obtain a temperature measured in the identification information receiving device, specify a temperature section in which the obtained temperature is included, and set the initial threshold value to the determination threshold value for said temperature section. The determination threshold value in said temperature section may be the last determination threshold value accumulated in said temperature section or may be a representative value of all the determination threshold values belonging to said temperature section. Note that in this example, a temperature sensor for measuring the internal temperature of the identification information receiving device needs to be installed therein.

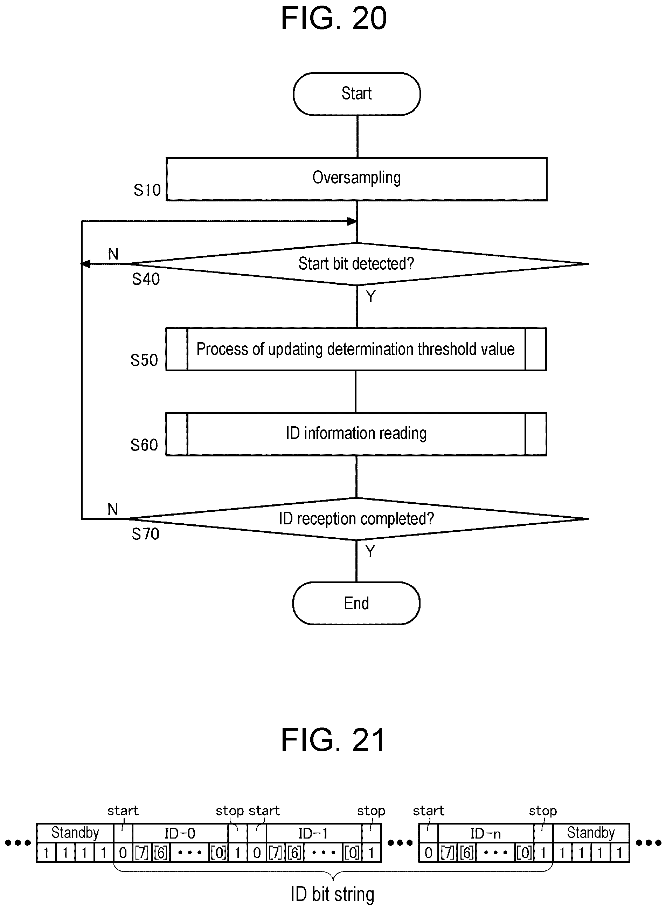

Fig. 20 is a flowchart illustrating overall operation example 2 of the identification information receiving device according to the exemplary embodiment that is applied upon reception of the ID. In overall operation example 2 illustrated in Fig. 20, the processes in Step S30 and Step S40 are omitted as compared to the flowchart illustrating overall operation example 1 illustrated in Fig. 14. In overall operation example 1, the first determination threshold value (0) is generated on the basis of the specific bit string and the initial threshold value; in contrast, in overall operation example 2, the first determination threshold value (0) is set to the initial threshold value without changes.

Fig. 21 is a diagram illustrating data format example 3 including an ID bit string that corresponds to overall operation example 2. In data format example 3, a specific bit string is omitted as compared to data format example 1 illustrated in Fig. 8 and data format example 2 illustrated in Fig. 11.

In overall operation example 1, a plausible determination threshold value is estimated using a specific bit string received prior to reception of ID, and thus the reliability of the first determination threshold value improves. Meanwhile, in overall operation example 2, the process of generating the first determination threshold value can be omitted, meaning that the amount of processing can be reduced. Furthermore, since the specific bit string is omitted, the data format can be simplified.

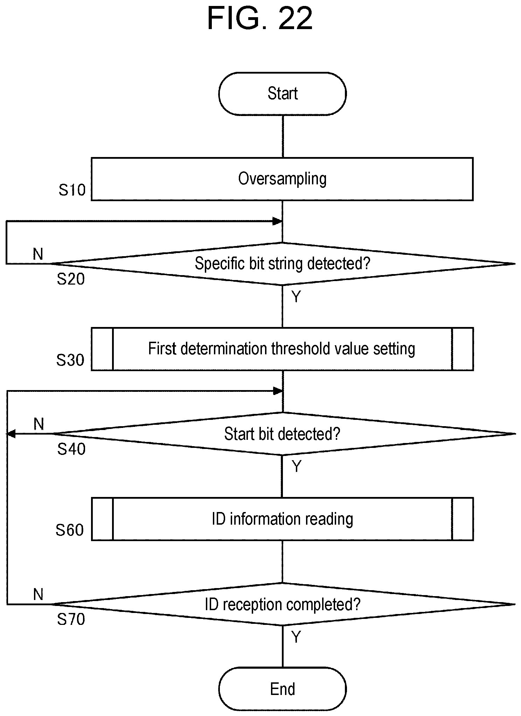

Fig. 22 is a flowchart illustrating overall operation example 3 of the identification information receiving device according to the exemplary embodiment that is applied upon reception of the ID. In overall operation example 3 illustrated in Fig. 22, the process in Step S50 is omitted as compared to the flowchart illustrating overall operation example 1 illustrated in Fig. 14. In overall operation example 3, the first determination threshold value (0) generated on the basis of the specific bit string and the initial threshold value continues to be used without being updated during reception of the ID. Note that when the ID information includes a bit string with one word, overall operation example 3 is always applied.

Overall operation example 3 is an operation example that is effective in an application where a significant fluctuation is less likely to occur in the electric current flowing to the power line during reception of ID (for example, when the data amount of the ID information is small and the communication lasts for a short period of time). In contrast, overall operation examples 1, 2 are operation examples that are effective in an application where a significant fluctuation is likely to occur in the electric current flowing to the power line during reception of ID. In overall operation examples 1, 2, the determination threshold value is sequentially updated on the basis of the received ID bit string, allowing the reliability of the determination threshold value to be maintained at a high level. Furthermore, when the proportion of bits "1" or bits "0" in the ID bit string is extremely unbalanced, the number of bits "1" or bits "0" sampled that is to be reflected on the determination threshold value is also unbalanced, meaning that the plausibility of the determination threshold value is reduced. By updating the determination threshold value while reflecting the immediately preceding determination threshold value, it is possible to maintain the reliability of the determination threshold value at a high level.

As described above, in the present exemplary embodiment, a specific bit string is transmitted before ID information is reported via a power line connecting battery pack 10 and vehicle 20, a determination threshold value for determining the ID information is calculated from values of the specific bit string that have been received, and then the determination threshold value is sequentially updated upon reception of the ID information. This can prevent false determination of the ID information superimposed on the electric current flowing to the power line, allowing for improved system reliability. Even when there are variations in the characteristics of components or changes in electric current consumption, for example, the determination threshold value can be maintained at an appropriate level. Furthermore, since there is no need to add hardware, it is possible to improve the system reliability without increasing the cost.

The present disclosure has been described thus far based on the exemplary embodiment. The exemplary embodiment is merely an example; a person having ordinary skill in the art will readily appreciate that various variations are possible as a combination of these structural elements and these processes and that these variations are also included in the scope of the present disclosure.

The above exemplary embodiment describes an example in which it is verified that battery pack 10 attached to the mounting slot of vehicle 20 and battery pack 10 communicating with vehicle 20 are the same. In this regard, the verification method according to the above exemplary embodiment can also be used to verify that battery pack 10 attached to the mounting slot of a charger and battery pack 10 communicating with the charger are the same. In this situation, the charger may be an identification information transmitting device and battery pack 10 may be an identification information receiving device; alternatively, battery pack 10 may be an identification information transmitting device and the charger may be an identification information receiving device.

The above exemplary embodiment describes an example in which battery pack 10 incorporating storage battery 11 is used. In this regard, a capacitor pack incorporating a capacitor that includes an electric double layer capacitor cell, a lithium ion capacitor cell, or the like may be used. The battery pack and the capacitor pack are collectively referred herein to as an energy storage pack.

The present disclosure is suitable for application to vehicle 20 that does not include its own battery, but the application of the present disclosure to vehicle 20 that includes its own battery is not excluded. Therefore, vehicle 20 is not limited to the electric assisted bicycle; examples of vehicle 20 include an electric motorcycle (an electric scooter), an electric kick scooter, an electric vehicle (including a low-speed electric vehicle such as a golf cart or a land car), and a railroad car. Furthermore, an object to which the energy storage pack is attached is not limited to vehicle 20; examples of said object include an electric mobile vehicle such as an electric boat or ship or a multirotor (a drone).

Note that the exemplary embodiment may be specified according to the following items.

[Item 1] An identification information receiving device (10) connected to an identification information transmitting device (20) by a power line, the identification information receiving device (10) including:
a measurement value obtainment unit (151) that obtains a measurement value of an electric current or a voltage in the power line;
an identification information reading unit (155) that reads identification information as binary data by determining whether the measurement value corresponding to each bit of the identification information is greater or less than a determination threshold value (other than 0), the identification information being defined by a plurality of bits and superimposed on the electric current or the voltage in the power line by the identification information transmitting device (20); and
a threshold value setting unit (154) that sets the determination threshold value on the basis of an initial threshold value (other than 0) and the measurement value corresponding to each bit of threshold value verification information defined by a plurality of bits and superimposed on the electric current or the voltage in the power line by the identification information transmitting device (20) before the identification information.

Thus, it is possible to prevent false determination of the identification information superimposed on the electric current or the voltage in the power line, allowing for improved system reliability.

[Item 2] The identification information receiving device (10) according to item 1, wherein
the threshold value setting unit (154) compares the initial threshold value and the measurement value corresponding to each bit of the threshold value verification information, calculates two representative values that are a representative value of the measurement value greater than or equal to the initial threshold value and a representative value of the measurement value less than the initial threshold value, and sets the determination threshold value to an intermediate value between the two representative values.

Thus, it is possible to set an appropriate determination threshold value by comparing the initial threshold value and each bit of the threshold value verification information superimposed on the electric current or the voltage in the power line.

[Item 3] The identification information receiving device (10) according to item 1, wherein
the threshold value setting unit (154) performs the following:
holding converted threshold value verification information obtained by converting 0 in a bit string constituting the threshold value verification information into a negative value and setting a value corresponding to 1 in the bit string and a value corresponding to 0 in the bit string to have equal absolute values;
sequentially calculating a difference value by subtracting the initial threshold value from the measurement value corresponding to each bit of the threshold value verification information superimposed on the electric current or the voltage in the power line;
specifying, on the basis of a sum of products in respective digits of a difference value sequence and the converted threshold value verification information, the difference value sequence in a section with a highest degree of correlation, the difference value sequence being an array of the difference value; and
calculating two representative values that are a representative value of a positive value included in the difference value sequence specified and a representative value of a negative value included in the difference value sequence specified, and setting the determination threshold value to an intermediate value between the two representative values.

Thus, it is possible to set an appropriate determination threshold value on the basis of the threshold value verification information superimposed on the electric current or the voltage in the power line and the autocorrelation of the threshold value verification information at the receiving end.

[Item 4] The identification information receiving device (10) according to item 1, wherein
the threshold value setting unit (154) compares the determination threshold value and the measurement value corresponding to each bit of the identification information superimposed on the electric current or the voltage in the power line, calculates two representative values that are a representative value of the measurement value greater than or equal to the determination threshold value and a representative value of the measurement value less than the determination threshold value, and sets the determination threshold value to an intermediate value between the two representative values as an updated determination threshold value, and
the identification information reading unit (155) reads the identification information as the binary data by determining whether the measurement value corresponding to each bit of the identification information is greater or less than the updated determination threshold value.

Thus, it is possible to read the identification information on the basis of a reliable determination threshold value.

[Item 5] The identification information receiving device (10) according to item 1, wherein
the identification information transmitting device (20) superimposes a plurality of pieces of the identification information on the electric current or the voltage in the power line, and
the threshold value setting unit (154) performs the following:
   comparing the measurement value corresponding to each bit of a first piece of the identification information superimposed on the electric current or the voltage in the power line and a first determination threshold value that is the determination threshold value set for a first time, calculating two representative values that are a representative value of the measurement value greater than or equal to the first determination threshold value and a representative value of the measurement value less than the determination threshold value, and setting the determination threshold value to an intermediate value between the two representative values as an updated determination threshold value; and
   comparing the measurement value corresponding to each bit of second and subsequent pieces of the identification information superimposed on the electric current or the voltage in the power line and the updated determination threshold value that has been set upon reading of an immediately preceding piece of the identification information, calculating two representative values that are a representative value of the measurement value greater than or equal to the updated determination threshold value and a representative value of the measurement value less than the updated determination threshold value, and setting the determination threshold value to an intermediate value between the two representative values as a new updated determination threshold value.

Thus, it is possible to improve the reliability of the determination threshold value by sequentially updating the determination threshold value.

[Item 6] The identification information receiving device (10) according to item 1, wherein
the identification information transmitting device (20) superimposes a plurality of pieces of the identification information on the electric current or the voltage in the power line,
the threshold value setting unit (154) compares the measurement value corresponding to each bit of a first piece of the identification information superimposed on the electric current or the voltage in the power line and a first determination threshold value that is the determination threshold value set for a first time, calculates two representative values that are a representative value of the measurement value greater than or equal to the first determination threshold value and a representative value of the measurement value less than the determination threshold value, and sets the determination threshold value to an intermediate value between the two representative values as an updated determination threshold value,
the identification information reading unit (155) reads the first piece of the identification information as the binary data by determining whether the measurement value corresponding to each bit of the first piece of the identification information is greater or less than the updated determination threshold value,
the threshold value setting unit (154) compares the measurement value corresponding to each bit of second and subsequent pieces of the identification information superimposed on the electric current or the voltage in the power line and the updated determination threshold value that has been set upon reading of an immediately preceding piece of the identification information, calculates two representative values that are a representative value of the measurement value greater than or equal to the updated determination threshold value and a representative value of the measurement value less than the updated determination threshold value, and sets the determination threshold value to an intermediate value between the two representative values as a new updated determination threshold value, and
the identification information reading unit (155) reads the second and subsequent pieces of the identification information as the binary data by determining whether the measurement value corresponding to each bit of the second and subsequent pieces of the identification information is greater or less than the new updated determination threshold value.

Thus, by updating the determination threshold value on the basis of the identification information being received and then using said determination threshold value to determine said identification information, it is possible to improve the accuracy of determining said identification information.

[Item 7] The identification information receiving device (10) according to item 1, further including:
a determination threshold value record holding unit (156) that holds a record of the determination threshold value, wherein
the threshold value setting unit (154) sets the initial threshold value on the basis of at least one determination threshold value held in the determination threshold value record holding unit (156).

Thus, it is possible to set an appropriate initial threshold value.

[Item 8] An energy storage pack (10) that is detachable and portable and serves as the identification information receiving device (10) according to any one of items 1 to 7.

Thus, it is possible to provide an energy storage pack (10) with improved system reliability that is capable of preventing false determination of the identification information superimposed on the electric current or the voltage in the power line.

[Item 9] An identification information receiving method including:
obtaining, by an identification information receiving device (10), a measurement value of an electric current or a voltage in a power line connecting an identification information transmitting device (20) and the identification information receiving device (10);
reading identification information as binary data by determining whether the measurement value corresponding to each bit of the identification information is greater or less than a determination threshold value (other than 0), the identification information being defined by a plurality of bits and superimposed on the electric current or the voltage in the power line by the identification information transmitting device (20); and
setting the determination threshold value on the basis of an initial threshold value (other than 0) and the measurement value corresponding to each bit of threshold value verification information defined by a plurality of bits and superimposed on the electric current or the voltage in the power line by the identification information transmitting device (20) before the identification information.

Thus, it is possible to prevent false determination of the identification information superimposed on the electric current or the voltage in the power line, allowing for improved system reliability.

### Reference Signs List

- 10: Battery pack

- 20: vehicle
- 11: storage battery
- 12: first relay
- 13: first current sensor
- 14: first power supply circuit
- 15: first control unit
- 16: first wireless communication unit
- 17: first antenna
- 18: first ID superimposing circuit
- 21: motor
- 22: inverter
- 23: second relay
- 24: second power supply circuit
- 25: second control unit
- 26: second wireless communication unit
- 27: second antenna
- 28: second ID superimposing circuit
- 29: voltage detection circuit
- T1: power supply terminal
- T2: power receiving terminal
- Lp: power line
- 151: measurement value obtainment unit
- 152: A/D conversion unit
- 153: data buffer
- 154: threshold value setting unit
- 155: ID reading unit
- 156: determination threshold value record holding unit

## Claims

1. An identification information receiving device connected to an identification information transmitting device by a power line, the identification information receiving device comprising:
a measurement value obtainment unit that obtains measurement values of an electric current or a voltage of the power line;
an identification information reading unit that reads identification information as binary data by determining whether a measurement value corresponding to each bit of the identification information among the measurement values is greater or less than a determination threshold value other than 0, the identification information being defined by a plurality of bits and superimposed on the electric current or the voltage of the power line by the identification information transmitting device; and
a threshold value setting unit that sets the determination threshold value based on (i) an initial threshold value other than 0 and (ii) a measurement value corresponding to each bit of threshold value verification information defined by a plurality of bits among the measurement values, the threshold value verification information being superimposed on the electric current or the voltage in the power line by the identification information transmitting device before the identification information is superimposed.

2. The identification information receiving device according to claim 1, wherein
the threshold value setting unit compares the initial threshold value and the measurement value corresponding to each bit of the threshold value verification information, calculates two representative values that are a representative value of the measurement value greater than or equal to the initial threshold value and a representative value of the measurement value less than the initial threshold value, and sets the determination threshold value to an intermediate value between the two representative values.

3. The identification information receiving device according to claim 1, wherein
the threshold value setting unit performs:
holding converted threshold value verification information obtained by converting 0 in a bit string constituting the threshold value verification information into a negative value and setting a value corresponding to 1 in the bit string and a value corresponding to 0 in the bit string to have equal absolute values;
sequentially calculating a difference value by subtracting the initial threshold value from the measurement value corresponding to each bit of the threshold value verification information superimposed on the electric current or the voltage of the power line;
specifying, based on a sum of products in respective digits of a difference value sequence and the converted threshold value verification information, the difference value sequence in a section with a highest degree of correlation, the difference value sequence being an array of the difference value; and
calculating two representative values that are a representative value of a positive value included in the difference value sequence specified and a representative value of a negative value included in the difference value sequence specified, and setting the determination threshold value to an intermediate value between the two representative values.

4. The identification information receiving device according to claim 1, wherein
the threshold value setting unit compares the determination threshold value and the measurement value corresponding to each bit of the identification information superimposed on the electric current or the voltage of the power line, calculates two representative values that are a representative value of the measurement value greater than or equal to the determination threshold value and a representative value of the measurement value less than the determination threshold value, and sets the determination threshold value to an intermediate value between the two representative values as an updated determination threshold value, and
the identification information reading unit reads the identification information as the binary data by determining whether the measurement value corresponding to each bit of the identification information is greater or less than the updated determination threshold value.

5. The identification information receiving device according to claim 1, wherein
the identification information transmitting device superimposes a plurality of pieces of the identification information on the electric current or the voltage of the power line, and
the threshold value setting unit performs:
comparing a measurement value corresponding to each bit of a first piece of the identification information superimposed on the electric current or the voltage of the power line and a first determination threshold value that is the determination threshold value set for a first time, calculating two representative values that are a representative value of the measurement value greater than or equal to the first determination threshold value and a representative value of the measurement value less than the determination threshold value, and setting the determination threshold value to an intermediate value between the two representative values as an updated determination threshold value, the measurement value being included in the measurement values; and
comparing a measurement value corresponding to each bit of second and subsequent pieces of the identification information superimposed on the electric current or the voltage of the power line and the updated determination threshold value that has been set upon reading of an immediately preceding piece of the identification information, calculating two representative values that are a representative value of the measurement value greater than or equal to the updated determination threshold value and a representative value of the measurement value less than the updated determination threshold value, and setting the determination threshold value to an intermediate value between the two representative values as a new updated determination threshold value, the measurement value being included in the measurement values.

6. The identification information receiving device according to claim 1, wherein
the identification information transmitting device superimposes a plurality of pieces of the identification information on the electric current or the voltage of the power line,
the threshold value setting unit compares a measurement value corresponding to each bit of a first piece of the identification information superimposed on the electric current or the voltage of the power line and a first determination threshold value that is the determination threshold value set for a first time, calculates two representative values that are a representative value of the measurement value greater than or equal to the first determination threshold value and a representative value of the measurement value less than the determination threshold value, and sets the determination threshold value to an intermediate value between the two representative values as an updated determination threshold value, the measurement value being included in the measurement values,
the identification information reading unit reads the first piece of the identification information as the binary data by determining whether the measurement value corresponding to each bit of the first piece of the identification information is greater or less than the updated determination threshold value,
the threshold value setting unit compares the measurement value corresponding to each bit of second and subsequent pieces of the identification information superimposed on the electric current or the voltage of the power line and the updated determination threshold value that has been set upon reading of an immediately preceding piece of the identification information, calculates two representative values that are a representative value of the measurement value greater than or equal to the updated determination threshold value and a representative value of the measurement value less than the updated determination threshold value, and sets the determination threshold value to an intermediate value between the two representative values as a new updated determination threshold value, and
the identification information reading unit reads the second and subsequent pieces of the identification information as the binary data by determining whether the measurement value corresponding to each bit of the second and subsequent pieces of the identification information is greater or less than the new updated determination threshold value.

7. The identification information receiving device according to claim 1, further comprising:
a determination threshold value record holding unit that holds a record of the determination threshold value, wherein
the threshold value setting unit sets the initial threshold value based on at least one determination threshold value held in the determination threshold value record holding unit.

8. An energy storage pack that is detachable and portable and serves as the identification information receiving device according to any one of claims 1 to 7.

9. An identification information receiving method comprising:
obtaining, by an identification information receiving device, measurement values of an electric current or a voltage of a power line connecting an identification information transmitting device and the identification information receiving device;
reading identification information as binary data by determining whether a measurement value corresponding to each bit of the identification information among the measurement values is greater or less than a determination threshold value other than 0, the identification information being defined by a plurality of bits and superimposed on the electric current or the voltage of the power line by the identification information transmitting device; and
setting the determination threshold value based on (i) an initial threshold value other than 0 and (ii) a measurement value corresponding to each bit of threshold value verification information defined by a plurality of bits among the measurement values, the threshold value verification information being superimposed on the electric current or the voltage of the power line by the identification information transmitting device before the identification information is superimposed.
